# EUROPÄISCHE PATENTANMELDUNG

(11) **EP 2 704 328 A1**
(43) Veröffentlichungstag der Anmeldung: **05.03.2014**
(21) Anmeldenummer: 13181589.6
(22) Anmeldetag: 23.08.2013
(51) Int. Cl.: H03K 17/95

(54) **Sensorvorrichtung und Verfahren zur Erfassung eines ferromagnetischen Betätigers**

(30) Priorität: 28.08.2012 DE 102012107931
(71) Anmelder: K.A. Schmersal Holding GmbH & Co. KG, 42279 Wuppertal (DE)
(72) Erfinder: Lausberg, Gerd, 44287 Dortmund (DE); Klees, Christoph, 51674 Wiehl (DE)
(74) Vertreter: Kalkoff & Partner

(57) **Zusammenfassung**

Beschrieben sind eine Sensorvorrichtung und ein Verfahren zur Erfassung eines ferromagnetischen Betätigers (20). Ein erster Magnetfeldsensor (14) ist in Erfassungsrichtung (E) vor dem Magneten (12) angeordnet. Ein zweiter Magnetfeldsensor (16) ist hinter dem Magneten (12) angeordnet. Um mit geringem Bauaufwand eine Sensorvorrichtung mit guter Erfassungsreichweite zu erzielen, wird durch Bildung der Differenz der Sensorsignale der Magnetfeldsensoren (14, 16) ein Erfassungssignal (S) erzeugt.

## Beschreibung

Die Erfindung betrifft eine Sensorvorrichtung und ein Verfahren zur Erfassung eines ferromagnetischen Betätigers. Insbesondere betrifft die Erfindung eine Vorrichtung und ein Verfahren, bei dem das Vorhandensein sowie ggf. der Abstand, in dem sich der Betätiger in einer Erfassungsrichtung von der Sensorvorrichtung befindet, durch dessen Beeinflussung eines magnetischen Feldes erkannt wird.

Es sind verschiedene Sensorprinzipien zur Erfassung von Objekten bekannt, die in verschiedenen Bereichen eingesetzt werden. Dabei geht es jeweils um die Erfassung eines Objektes, das hier als Betätiger bezeichnet wird. Dabei kann bspw. die Sensorvorrichtung einen jeweils zugeordneten, bekannten Betätiger erfassen, wie z. B. bei einem Türkontakt. Ebenso kann eine entsprechende Sensorvorrichtung eingesetzt werden, um beliebige Objekte zu erfassen, bspw. Gegenstände auf einem Förderband etc.

DE 10 2010 043 010 A1 zeigt ein Beispiel einer Sensorvorrichtung nach dem induktiven Sensorprinzip. Dabei erzeugt eine Sendespule ein gepulstes Magnetfeld, das in einem Target einen Wirbelstrom hervorruft, der ein veränderliches Sekundär-Magnetfeld zur Folge hat. Eine GMR-Zelle als Magnetsensor wird als Empfänger verwendet, um ein Empfangssignal zu erzeugen.

Eine Sensorvorrichtung nach magnetischem Sensorprinzip offenbart die DE 34 38 120. Hierbei weist ein Näherungsschalter zum Positionsnachweis eines Maschinenelements zwei identische Magnetfeldsensoren auf, die auf einer Trägerplatte im Abstand voneinander angeordnet sind. Ein durch den Näherungsschalter zu detektierendes Maschinenelement ist mit einer Bohrung versehen, in welcher ein Stabmagnet gehalten ist. Das Magnetfeld wird durch die Magnetfeldsensoren detektiert, die mit einer Differenzschaltung verbunden sind. Dabei sind die Magnetfeldsensoren relativ zueinander so angeordnet, dass die Vorzugsrichtungen parallel stehen und die Magnetfeldsensoren eine gemeinsame Mittelebene besitzen, die senkrecht zur Vorzugsrichtung verläuft. Der Näherungsschalter ist relativ zu Feldlinien des Magnetfelds so angeordnet, dass diese parallel zu den Vorzugsrichtungen verlaufen und die Magnetfeldsensoren durchdringen.

Es ist Aufgabe der Erfindung, eine Sensorvorrichtung und ein Verfahren zur Erfassung eines ferromagnetischen Betätigers anzugeben, bei dem mit einer einfachen Schaltung eine verlässliche Detektion mit möglichst hoher Reichweite gegeben ist.

Diese Aufgabe wird gelöst durch eine Sensorvorrichtung gemäß Anspruch 1 und ein Verfahren zur Erfassung eines ferromagnetischen Betätigers gemäß Anspruch 15. Abhängige Ansprüche beziehen sich auf vorteilhafte Ausführungsformen der Erfindung.

Erfindungsgemäß umfasst die Sensorvorrichtung einen Magneten, bevorzugt einen Permanentmagneten, und mindestens einen ersten und einen zweiten Magnetfeldsensor. Als Magnetmaterialien kommen insbesondere bekannte Materialien von Permanentmagneten in Frage. Als Magnetfeldsensoren können prinzipiell alle Arten von elektrischen Bauelementen verwendet werden, die abhängig von der jeweiligen magnetischen Feldstärke unterschiedliches elektrisches Verhalten zeigen. Insbesondere bevorzugt sind sensible Magnetfeldsensoren wie bspw. AMR- oder GMR-Sensoren und - besonders bevorzugt - Halleffekt-Sensoren.

Bei dem Betätiger kann es sich um ein beliebiges ferromagnetisches Element handeln. Ebenso ist es möglich, dass der Betätiger selbst ein Permanent- oder Elektromagnet ist.

Die Sensorvorrichtung weist eine Erfassungsrichtung auf, die üblicherweise so angeordnet ist, dass die Annäherung des zu erfassendes Betätigers aus dieser Erfassungsrichtung erfolgt. In Erfassungsrichtung ist der erste Magnetfeldsensor vor dem Magneten und der zweite Magnetfeldsensor hinter dem Magneten angeordnet.

Grundgedanke dieser Anordnung ist es, dass sich bei einer Annäherung eines ferromagnetischen Betätigers aus der Erfassungsrichtung an den Magneten eine Feldänderung vor den Magneten, also im Bereich des ersten Magnetfeldsensors ergibt. Aufgrund der größeren räumlichen Distanz zum hinter dem Magneten angeordneten Magnetfeldsensor erfolgt gleichzeitig keine oder eine wesentlich geringere Beeinflussung des Feldes dort. Für die erfindungsgemäße Anordnung ist es besonders bevorzugt, dass der erste und zweite Magnetfeldsensor mit dem Magneten mindestens im Wesentlichen in einer Linie angeordnet sind. Der oben genannte Zweck wird jedoch auch bei gewissen Abweichungen von einer solchen Anordnung erreicht.

Die relative Anordnung des Magneten und der Magnetfeldsensoren ist - mindestens während des Messvorgangs - fest. Bevorzugt sind die Elemente an einem gemeinsamen Element, bspw. einem Träger, Gehäuse etc. in der vorgegebenen Sensoranordnung befestigt.

Erfindungsgemäß sind die Magnetfeldsensoren mit einer Auswerteeinheit verbunden, die durch Bildung der Differenz der Sensorsignale ein Ausgangssignal erzeugt. Bei der Auswerteeinheit handelt es sich um eine elektrische Schaltung, die - wie in den nachfolgenden Beispielen gezeigt wird - sehr einfach aufgebaut werden kann. Die Differenzbildung ist selbst bei Verwendung diskreter Bauteile mit nur wenigen Elementen erreichbar. Durch einen solchen einfachen Aufbau der Auswerteeinheit ist ein kostengünstiger Sensor realisierbar.

Gleichzeitig hat sich erwiesen, dass das erfindungsgemäße Sensorprinzip mit der Anordnung eines Magnetfeldsensors vor dem Magneten, d. h. in Erfassungsrichtung, und einem (Referenz-)Magnetfeldsensor hinter dem Magneten, verbunden mit einer Differenzbildung, zu einer hochgenauen Erfassung führt, die erhebliche Sensorreichweiten ermöglicht und gleichzeitig gegenüber Störeinflüssen, bspw. Temperaturschwankungen, Störfelder, etc. relativ robust ist.

Gemäß einer vorteilhaften Weiterbildung ist vorgesehen, dass der Magnet in Betätigungsrichtung ausgerichtet ist, also mit seinem magnetischen Nord- oder Südpol in Betätigungsrichtung zeigt. Dann ist die Feldstärke am Ort der Magnetfeldsensoren besonders hoch, was zu einer verbesserten Reichweite führt.

Die Auswerteeinheit umfasst bevorzugt einen Differenzverstärker zur Bildung des Differenzsignals. Eine derartige Schaltung lässt sich in bekannter Weise einfach realisieren. Weiter ist bevorzugt, dass die Auswerteeinheit eine Schwellwerteinheit umfasst, der das Differenzsignal zugeführt wird. So wird erreicht, dass ein Ansprechen der Sensorvorrichtung erst bei sicherer Detektion - nämlich der Überschreitung eines Schwellwerts - erfolgt. Als Schwellwerteinheit kann bspw. eine bekannte Schmitt-Trigger-Schaltung dienen. Besonders bevorzugt ist es, die Schaltung der Auswerteeinheit mit einem integrierten Schaltkreis mit zwei Operationsverstärkern zu realisieren, wobei einer der Operationsverstärker des IC als Differenzverstärker und der andere als Schwellwertschalter geschaltet ist. So kann mit dem genannten IC und minimaler zusätzlicher passiver Beschaltung bereits die gesamte Auswerteschaltung realisiert werden.

Es ist bevorzugt, dass der erste und zweite Magnetfeldsensor sowie der Magnet zueinander so angeordnet sind, dass ohne Anwesenheit eines Betätigers die Differenz der Ausgangssignale der Magnetfeldsensoren unterhalb einer Detektionsschwelle liegt. Dabei ist besonders bevorzugt, dass die Differenz mindestens im Wesentlichen Null ist. Der Fachmann versteht in diesem Zusammenhang, dass durch unvermeidliche Störsignale, Rauschen etc. die Differenz bei exakter Messung nie vollständig Null sein wird.

Um ein Differenzsignal von unterhalb einer geringen Detektionsschwelle, bevorzugt im Wesentlichen Null zu erhalten, werden die Magnetfeldsensoren an Orten mit gleicher magnetischer Feldstärke angeordnet. Beispielsweise im Fall eines reinen Luftmagnetfeldes, d. h. ohne Anwesenheit von ferromagnetischen Elementen im Nahbereich, werden Sensorsignale, deren Differenz im Wesentlichen Null ist erreicht, indem der erste und zweite Magnetfeldsensor in gleichem Abstand vom Magneten angeordnet werden und gleichsinnig angeschlossen sind. Dann wird - ohne äußere Beeinflussung, wie sie die Anwesenheit des zu detektierenden Betätigers darstellt - die Differenz zu Null (abgesehen von unvermeidlichen Störsignalen, die ggf. durch die bereits erwähnte Schwellwerteinheit unterdrückt werden können).

In einer alternativen Anordnung umfasst der Magnetfeldsensor ferromagnetische Elemente. Insbesondere kann eine Abschirmung vorgesehen sein. Diese Abschirmung kann bspw. seitlich zur Erfassungsrichtung angeordnet werden, bevorzugt so, dass sie den Magneten und die Magnetfeldsensoren umschließt. Alternativ oder zusätzlich hierzu kann eine Abschirmung auch rückseitig zur Erfassungsrichtung angeordnet sein, so dass sie insbesondere den zweiten Magnetfeldsensor abschirmt. Nach vorne, also in Erfassungsrichtung, hingegen, sollte die Erfassung nicht durch ferromagnetische Elemente gestört werden.

Ist durch die Anordnung von ferromagnetischen Elementen, insbesondere eine Abschirmung, das Magnetfeld des Magneten im Ruhezustand, d. h. ohne Anwesenheit des zu detektierenden Betätigers, unsymmetrisch, so sind bevorzugt der erste und zweite Magnetfeldsensor nicht in gleichem Abstand vom Magneten anzuordnen, sondern in solchen unterschiedlichen Abständen, dass sich wiederum die Differenz der Sensorsignale im Wesentlichen zu Null ergibt. Alternativ wäre es möglich, einen durch die Anordnung im unsymmetrischen Feld vorhandenen Bias mittels entsprechender zusätzlicher Beschaltung zu kompensieren. Da die Schaltung aber durch die beschriebene Ausrichtung noch einfacher gehalten werden kann, ist es bevorzugt, die Abstimmung des Differenzsignals zu Null durch die beschriebene Anordnung sicherzustellen.

Gemäß einer bevorzugten Ausführung können der Magnet und die Magnetfeldsensoren in einem länglichen Gehäuse angeordnet sein, bspw. einem röhrenförmigen Gehäuse. Dieses kann bevorzugt in Erkennungsrichtung durch ein nichtmagnetisches Material, bspw. durch eine Kunststoff-Kappe abgeschlossen sein. Die Detektion kann durch ein solches nichtmagnetisches Material hindurch erfolgen. In rückseitige Richtung und zu den Seiten hin kann das Gehäuse wie beschrieben ferromagnetisch sein oder ferromagnetische Bestandteile aufweisen, um eine Abschirmung zu erzielen.

Nachfolgend werden Ausführungsformen der Erfindung anhand von Zeichnungen näher beschrieben. Dabei zeigen:
- Fig. 1: in schematischer Darstellung eine erste Ausführungsform Elemente einer Sensoranordnung;
- Fig. 2: in schematischer Schaltbild-Darstellung die Sensoranordnung aus Fig. 1 mit einer Auswerteschaltung;
- Fig. 3: ein Schaltbild der Auswerteschaltung aus Fig. 2;
- Fig. 4: in teilweise schematischem Längsschnitt eine zweite Ausführungsform einer Sensorvorrichtung.

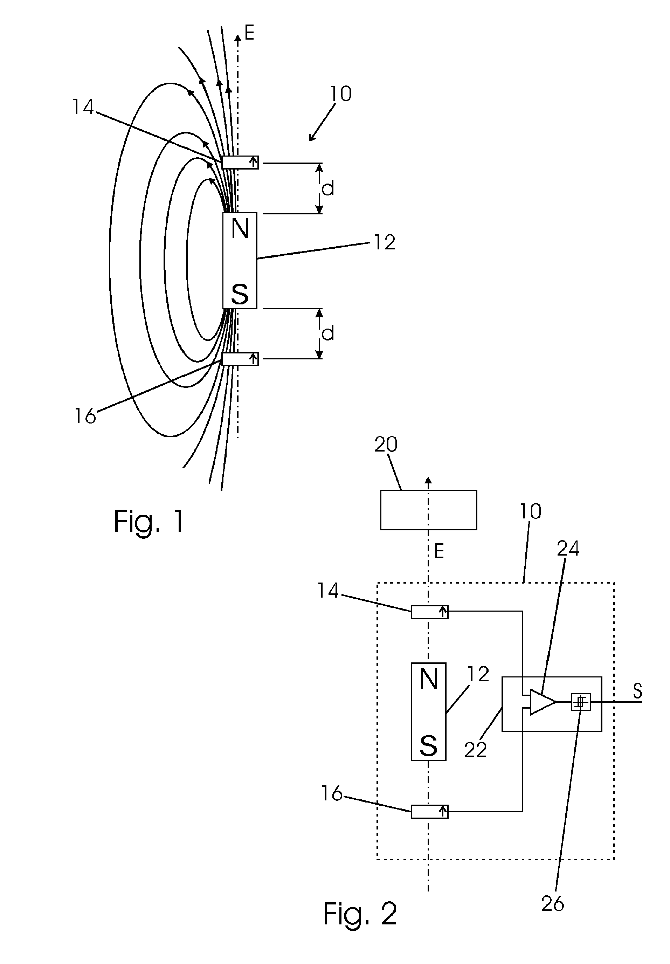

In Fig. 1 sind in einer schematischen Seitenansicht Elemente einer Sensorvorrichtung 10 dargestellt, und zwar ein Permanentmagnet 12, ein in Erfassungsrichtung E vor dem Magneten 12 angeordneter erster Magnetfeldsensor 14 und ein in Erfassungsrichtung E hinter dem Magneten 12 angeordneter zweiter Magnetfeldsensor 16. Dabei sind der erste Magnetfeldsensor 14, der Magnet 12 und der zweite Magnetfeldsensor 16 in einer Linie angeordnet, die im gezeigten Beispiel der Erfassungsrichtung E entspricht.

Der Magnet 12 ist von länglicher Form und in Erfassungsrichtung E ausgerichtet, so dass der magnetische Nordpol in Erfassungsrichtung E und der magnetische Südpol in die entgegengesetzte Richtung weist.

Die Magnetfeldsensoren 14, 16 sind im gezeigten Beispiel Hall-Sensoren, die die magnetische Feldstärke innerhalb einer Sensorfläche messen. Die Sensorflächen der Magnetfeldsensoren 14, 16 sind dabei jeweils in Richtung auf den Magneten 12 ausgerichtet, erstrecken sich also senkrecht zur Erfassungsrichtung E. Aufgrund dieser Ausrichtung der Magnetfeldsensoren 14, 16 mit ihrer Vorzugsrichtung parallel zur Erfassungsrichtung E und damit zur stärksten Komponente des Magnetfeldes wird eine relativ hohe magnetische Feldstärke erfasst.

Die verwendeten Hall-Sensoren weisen bevorzugt hohe Empfindlichkeit auf, d. h. die erzeugte Hall-Spannung ist in Abhängigkeit von der magnetischen Feldstärke so hoch, so dass bereits kleinere Änderungen der magnetischen Feldstärke zu messbaren Spannungsdifferenzen führen. Als Hall-Sensoren können bspw. integrierte Sensor-Schaltkreise verwendet werden.

In Fig. 1 ist schematisch das durch den Magneten 12 erzeugte magnetische Feld dargestellt, zur besseren Übersicht nur die linke Hälfte hiervon. Im gezeigten ersten Beispiel handelt es sich um eine einfache Feldverteilung in der Luft, d. h. ohne dass ferromagnetische Materialien den Feldverlauf beeinflussen. Wie gezeigt ergibt sich eine symmetrische Feldverteilung in Erfassungsrichtung E sowie in Gegenrichtung. Die Magnetfeldsensoren 14, 16 sind dabei mit gleichem Abstand d vor bzw. hinter dem Magneten 12 angeordnet. Wie durch einen Pfeil gekennzeichnet sind sie gleichsinnig gepolt. Die Abstände der Sensoren 14, 16 sind dabei in Abhängigkeit von deren Sensitivität und der magnetischen Feldstärke so gewählt, dass die magnetische Feldstärke nicht bereits zur Sättigung führt. Bei den verwendeten integrierten Hall-Sensoren ist das Ausgangssignal linear von der gemessenen Feldstärke abhängig. Als Folge der in Fig. 1 dargestellten symmetrischen Feldverteilung und der symmetrischen, gleichsinnigen Anordnung sind die von den Magnetfeldsensoren 14, 16 abgegebenen magnetischen Sensorsignale identisch, solange keine äußere Störung eintritt.

In Fig. 2 ist gezeigt, wie dies zur Erfassung eines ferromagnetischen Betätigers 20 durch die Sensorvorrichtung 10 genutzt wird. Dabei sind die Magnetfeldsensoren 14, 16 an eine Auswerteeinheit (Auswerteschaltung) 22 angeschlossen. Diese umfasst, wie unten näher erläutert wird, einen Differenzverstärker 24, dem die Sensorsignale der Magnetfeldsensoren 14, 16 zugeführt werden. Das hieraus gebildete Differenzsignal wird einem Schwellwertschalter 26 zugeführt, der daraus ein Erfassungssignal S erzeugt.

Ohne Anwesenheit des ferromagnetischen Betätigers 20 heben sich die Signale der Magnetfeldsensoren 14, 16 auf, so dass das gebildete Differenzsignal (bis auf Störungen, Rauschen etc.) Null ist, jedenfalls nicht oberhalb der im Schwellwertschalter 26 eingestellten Schaltschwelle liegt. Daher ist das Ausgangssignal S ebenfalls Null.

Nähert sich ein ferromagnetischer Körper, in diesem Fall der Betätiger 20, aus der Betätigungsrichtung E, so führt dies im Bereich vor dem Magneten 12 zu einer Veränderung des magnetischen Feldes, nämlich Bündelung. Hierdurch ergibt sich am Ort des ersten Magnetfeldsensors 14 eine höhere Feldstärke. Gleichzeitig wird das Magnetfeld hinter dem Magneten 12, also am Ort des zweiten Magnetfeldsensors 16 hierdurch nicht bzw. nur wenig beeinflusst, so dass das Signal des zweiten Magnetfeldsensors im Wesentlichen gleich bleibt. Hierdurch ergibt sich eine Differenz zwischen den Sensorsignalen, die durch den Differenzverstärker 24 verstärkt wird, so dass das Differenzsignal oberhalb der Schaltschwelle liegt und das Erfassungssignal S die Erfassung des Betätigers 20 anzeigt.

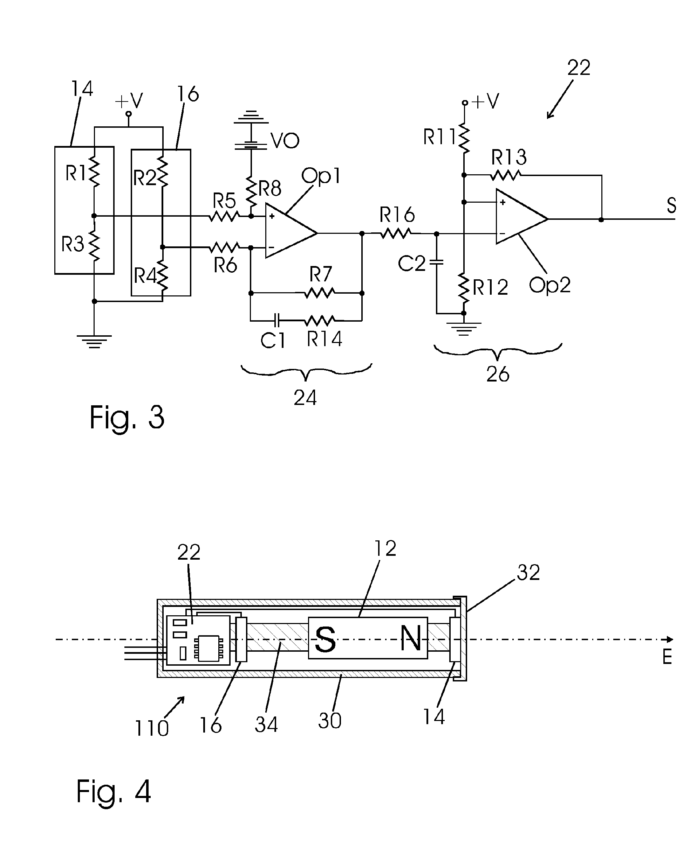

Die Schaltung der Auswerteeinheit 22 kann dabei wie in Fig. 3 dargestellt sehr einfach aufgebaut sein. In einer diskreten Ausführung kann die Schaltung neben wenigen passiven Bauelementen im Wesentlichen mit einem Doppel-Operationsverstärker-IC aufgebaut werden, wobei ein erster Operationsverstärker OP1 als Differenzverstärker 24 und ein zweiter Operationsverstärker OP2 als Schmitt-Trigger geschaltet ist.

Die Hall-Magnetfeldsensoren 14, 16 sind hierbei schematisch als Brückenschaltung von Widerstandselementen R1, R2, R₃, R₄ dargestellt, angeschlossen an die Versorgungsspannung V. Dabei liefert die Spannungsquelle VO (die auch als Spannungsteiler an der Versorgungsspannung V realisiert sein kann) eine Offset-Spannung, da im gezeigten Beispiel der Operationsverstärker OP1 als Single-Supply-Bauteil nur positive Spannungen verarbeiten kann. Durch den Offset wird im Beispiel sichergestellt, dass bei einer Differenz von Null eine minimale Ausgangsspannung von bspw. 1 V als Differenzsignal geliefert wird.

Die Sensorsignale werden über identische Eingangswiderstände R₅, R6 auf die Eingänge des ersten Operationsverstärkers OP1 geführt. Über einen Widerstand R₇ im Rückkoppelzweig kann die Verstärkung eingestellt werden. Zur Störungsunterdrückung ist eine RC-Reihenschaltung aus einem Widerstand R₁₄ und einer Kapazität C1 vorgesehen.

Das Differenzsignal wird über einen Eingangswiderstand R16 auf den mit Widerständen R11, R13 als Schmitt-Trigger geschalteten zweiten Operationsverstärker OP2 geführt, wobei durch eine Kapazität C2 und einen Widerstand R12 (Tiefpass) Störsignale gefiltert werden.

Der Schaltung 22 wird eine geeignete Versorgungsspannung V (auch für die Operationsverstärker, hier nicht dargestellt) zugeführt. Im Übrigen kann, wie dem Fachmann an sich bekannt ist, die Verstärkung sowie der Schwellwert durch geeignete Dimensionierung der Bauelemente erreicht werden.

Fig. 4 zeigt eine zweite, konkretere Ausführungsform einer Sensorvorrichtung 110, die in ihrem prinzipiellen Aufbau mit der ersten Ausführungsform übereinstimmt. Dabei sind zur ersten Ausführungsform identische Elemente mit gleichen Bezugszeichen bezeichnet. Im Folgenden wird nur auf die Unterschiede eingegangen.

Die Elemente der Sensorvorrichtung 110 sind in einem Gehäuse 30 angeordnet, das als umgebendes Stahl-Röhrchen mit rückseitigem Abschluss ausgebildet ist. In Erfassungsrichtung E ist das Stahl-Röhrchen geöffnet und das Gehäuse stattdessen durch eine Kunststoff-Kappe 32 abgeschlossen. Somit sind alle Elemente der Sensorvorrichtung 110 durch das Gehäuse 30 geschützt.

Innerhalb des Gehäuses 30 sind der Magnet 12 und die Magnetfeldsensoren 14, 16 an einem Kunststoff-Halter 34 fixiert. Auch die Auswerteschaltung 22 ist innerhalb des Gehäuses 30 angeordnet und elektrisch mit den Magnetfeldsensoren 14, 16 verbunden.

Durch das nach Stahl-Material des Gehäuses 30 ergibt sich im Inneren ein unsymmetrisches Magnetfeld. Dies wird kompensiert durch eine unsymmetrische Anordnung der Magnetfeldsensoren 14, 16 in verschiedenen Abständen vom Magneten 12, so dass sich auch bei dieser Anordnung im Wesentlichen identische Sensorsignale ergeben, solange - neben dem ferromagnetischen Gehäuse 30 - keine weiteren ferromagnetischen Körper in der Nähe vorhanden sind.

So kann durch Auswertung des Differenzsignals auch bei der Sensorvorrichtung 110 die Annäherung eines Betätigers in Erfassungsrichtung E erfasst werden, während in den anderen Richtungen eine Abschirmung erreicht wird.

Dabei ist die in Fig. 4 gezeigte Anordnung der Magnetfeldsensoren in unterschiedlichen Abständen lediglich schematisch zu verstehen. Für eine konkrete Sensorvorrichtung kann die sich durch das Gehäuse 30 ergebende Feldverteilung durch Simulation oder experimentell ermittelt und geeignete Positionen der Magnetfeldsensoren 14, 16 vorgegeben werden.

Die gezeigten Sensorvorrichtungen zeichnen sich durch einen sehr einfachen Aufbau aus, der mit wenigen Elementen auskommt. Dabei sind ohne Weiteres Sensorreichweiten von bspw. 2 cm erreichbar, in denen die Annäherung des ferromagnetischen Betätigers 20 erkannt wird. Ist der Betätiger selber magnetisch, können deutlich höhere Reichweite von bspw. 20 cm erreicht werden. Trotz der einfachen Beschaltung wird durch die Differenzbildung automatisch eine gute Temperaturkompensation und Robustheit gegen weitere Toleranzen und Störungen, die stets beide Magnetfeldsensoren 14, 16 betreffen, erreicht.

Von den gezeigten Ausführungen sind verschiedene Abweichungen möglich. Insbesondere kann die Sensorvorrichtung in verschiedensten Bauformen ausgeführt sein, wobei je nach gewünschter magnetischer Abschirmung sowie notwendigem mechanischem Schutz unterschiedliche Gehäusematerialien und -bauformen verwendet werden können.

Während die gezeigte Ausführung ein digitales Ausgangssignal S erzeugt, mit dem lediglich die Anwesenheit des Betätigers 20 angezeigt wird, sind andere Ausgangssignale möglich. Insbesondere kann ein Ausgangssignal, bspw. abgeleitet vom Differenzsignal, analog den Grad der Störung des Magnetfeldes und damit den Abstand des gesuchten Betätigers 20 anzeigen.

## Patentansprüche

1. Sensorvorrichtung zur Erfassung eines ferromagnetischen Betätigers (20), mit
- einem Magneten (12),
- und mindestens einem ersten und einem zweiten Magnetfeldsensor (14, 16),
**dadurch gekennzeichnet, dass**
- in Erfassungsrichtung (E) der erste Magnetfeldsensor (14) vor dem Magneten (12) und der zweite Magnetfeldsensor (16) hinter dem Magneten (12) angeordnet ist,
- und die Magnetfeldsensoren (14, 16) mit einer Auswerteeinheit (22) verbunden sind, in der durch Bildung der Differenz der Sensorsignale der Magnetfeldsensoren (14, 16) ein Erfassungssignal (S) erzeugt wird.

2. Sensorvorrichtung nach Anspruch 1, bei der
- der Magnet (12) in Erfassungsrichtung (E) ausgerichtet ist.

3. Sensorvorrichtung nach Anspruch 1 oder 2, bei der
- der erste und der zweite Magnetfeldsensor (14, 16) mit dem Magneten (12) in einer Linie (E) angeordnet sind.

4. Sensorvorrichtung nach einem der vorangehenden Ansprüche, bei der
- die Auswerteeinheit (22) zur Bildung eines Differenzsignals einen Differenzverstärker (24) umfasst, dem die Sensorsignale der Magnetfeldsensoren (14, 16) zugeführt werden.

5. Sensorvorrichtung nach Anspruch 4, bei der
- die Auswerteeinheit (22) eine Schwellwerteinheit (26) umfasst, der das Differenzsignal zugeführt wird.

6. Sensorvorrichtung nach Anspruch 5, bei der
- die Auswerteeinheit (22) einen integrierten Schaltkreis mit zwei Operationsverstärkern (OP1, OP2) umfasst, wobei einer der Operationsverstärker (OP1) als Differenzverstärker (24) und der andere Operationsverstärker (OP2) als Schwellwertschalter (26) geschaltet ist.

7. Sensorvorrichtung nach einem der vorangehenden Ansprüche, bei der
- der erste und der zweite Magnetfeldsensor (14, 16) so angeordnet sind, dass ohne Betätiger (20) die Differenz der Sensorsignale der Magnetfeldsensoren (14, 16) unterhalb einer Detektionsschwelle liegt.

8. Sensorvorrichtung nach Anspruch 7, bei der
- der erste und zweite Magnetfeldsensor (14, 16) in gleichem Abstand (d) vom Magneten (12) angeordnet sind.

9. Sensorvorrichtung nach einem der vorangehenden Ansprüche, bei der
- eine ferromagnetische Abschirmung (30) seitlich und/oder rückseitig zur Erfassungsrichtung (E) angeordnet ist.

10. Sensorvorrichtung nach einem der vorangehenden Ansprüche, bei der
- das Magnetfeld des Magneten (12) durch ferromagnetische Elemente der Sensorvorrichtung unsymmetrisch ist,
- wobei der erste und der zweite Magnetfeldsensor (14, 16) derartig in unterschiedlichen Abständen vom Magneten (12) angeordnet sind, dass ohne Betätiger (20) die Differenz der Sensorsignale der Magnetfeldsensoren (14, 16) Null ist.

11. Sensorvorrichtung nach Anspruch 9 oder 10, bei der
- der Magnet (12) und die Magnetfeldsensoren (14, 16) in einem länglichen Gehäuse (30) angeordnet sind.

12. Sensorvorrichtung nach Anspruch 11, bei der
- das Gehäuse (30) in Erfassungsrichtung (E) mit einem nicht-magnetischem Material (32) abgeschlossen ist.

13. Sensorvorrichtung nach einem der vorangehenden Ansprüche, bei der
- die Magnetfeldsensoren (14, 16) Hall-Sensoren sind.

14. Sensorvorrichtung nach einem der vorangehenden Ansprüche, bei der
- der Betätiger (20) ein Magnet ist.

15. Verfahren zur Erfassung eines ferromagnetischen Betätigers (20), bei dem
- in einer Erfassungsrichtung (E) ein erster Magnetfeldsensor (14) vor einem Magneten (12) und ein zweiter Magnetfeldsensor (16) hinter dem Magneten (12) angeordnet sind,
- und durch Bildung der Differenz der Sensorsignale der Magnetfeldsensoren (14, 16) ein Erfassungssignal (S) erzeugt wird.
